# EUROPEAN PATENT SPECIFICATION

(11) **EP 2 214 298 B1**
(45) Date of publication and mention of the grant of the patent: **18.04.2018**
(21) Application number: 10151726.6
(22) Date of filing: 27.01.2010
(51) Int. Cl.: H02M 3/158, H02M 1/44

(54) **DC-DC Converter and switching control circuit**
Gleichspannungswandler und Schaltungsteuerkreis
Convertisseur CC-CC et circuit de commande de commutation

(30) Priority: 30.01.2009 JP 2009020373
(43) Date of publication of application: 04.08.2010
(73) Proprietor: Mitsumi Electric Co., Ltd., Tama-shi, Tokyo 206-8567 (JP)
(72) Inventor: Satou, Akira, Tama-shi Tokyo 206-8567 (JP); Kawagoe, Osamu, Tama-shi Tokyo 206-8567 (JP)
(74) Representative: Grünecker Patent- und Rechtsanwälte PartG mbB

(56) References cited:
- EP-A1- 0 535 873
- US-A1- 2006 132 113
- YURI PANOV ET AL: "Design Considerations for 12-V/1.5-V, 50-A Voltage Regulator Modules" IEEE TRANSACTIONS ON POWER ELECTRONICS, IEEE SERVICE CENTER, PISCATAWAY, NJ, US, vol. 16, no. 6, 1 November 2001 (2001-11-01), XP011043606 ISSN: 0885-8993

## Description

### BACKGROUND OF THE INVENTION

### Field of the Invention

The present invention relates to a DC-DC converter of a switching regulator type to convert direct current and to a switching control circuit thereof, and especially relates to a technique useful for reducing spike noise due to switching operation in a synchronous rectification type DC-DC converter.

### Description of Related Art

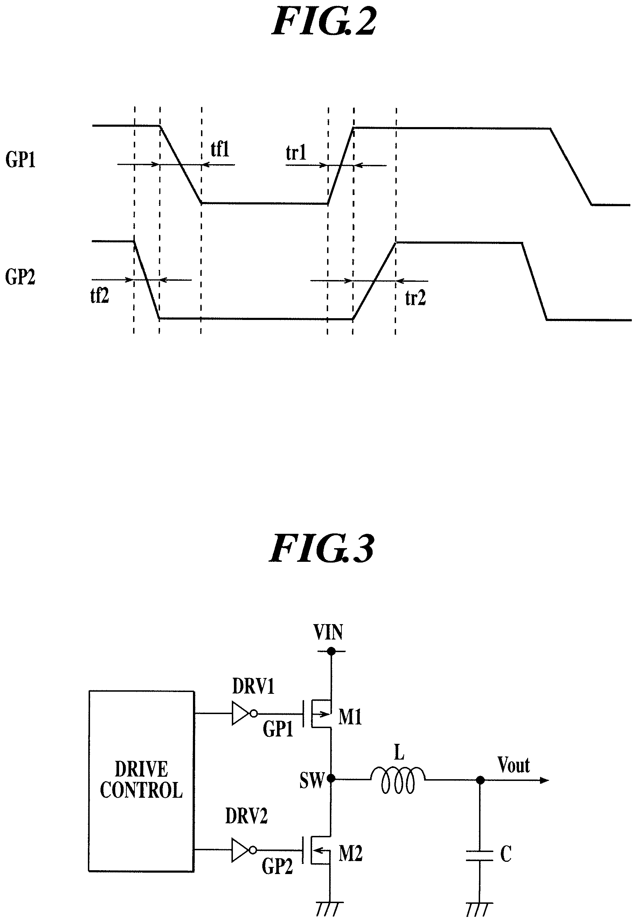

There has been a DC-DC converter of a switching regulator type as a circuit to convert an input direct voltage into a direct voltage having different potential. Such DC-DC converter includes, as shown in Fig. 3, a synchronous rectification type DC-DC converter which includes a driving switching element M1 to apply a DC power source voltage Vin supplied from a DC power source such as a battery to an inductor (coil) L to flow current so that energy is accumulated in the coil, and a rectifying switching element M2 to rectify the current flowing through the coil during an energy release period in which the driving switching element M1 is turned off, and wherein the driving switching element M1 and the rectifying switching element M2 are turned on/off in a complementary style so that power efficiency is further improved in comparison with the case of a diode rectification type DC-DC converter.

It has been heretofore known that spike noise occurs due to on/off operation of a switching element in the DC-DC converter of switching regulator type. Such spike noise causes an occurrence of common-mode noise to adversely affect peripheral circuits. In addition, such spike noise excessively requires voltage withstanding characteristics of elements such as a transistor constructing a control circuit to generate on/off signals for the switching element. For this reason, some techniques to reduce the spike noise have been proposed (for example, Japanese Patent Application Laid-Open Publication No. 2004-112958).

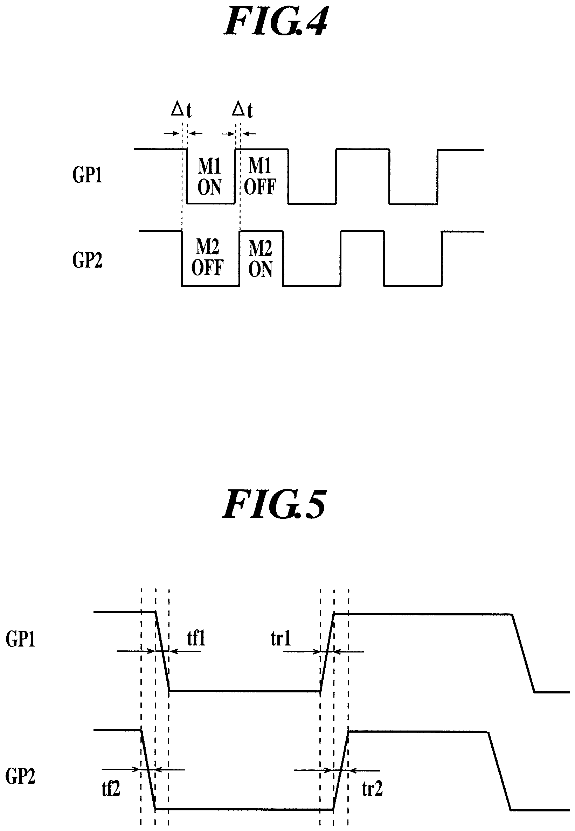

The inventers of the subject application considered in detail the cause of the spike noise which occurs in the DC-DC converter of switching regulator type like that shown in Fig. 3. The driving P-channel transistor M1 connected between a voltage input terminal VIN and one terminal of a coil L, and the rectifying N-channel transistor M2 connected between the one terminal of the coil L and a ground point, are driven into on/off states in a complementary style by in-phase gate driving pulses GP1, GP2. In order to prevent the M1 and M2 from becoming on-states at the same time, and to prevent penetrating current from flowing, the pulses GP1, GP2 are formed so as to have dead times tΔ as shown in Fig. 4, and formed so that falling times tf1, tf2 and raising times tr1, tr2 do not overlap with each other respectively.

When the transistors M1 and M2 are driven into on/off states by the above-mentioned pulses GP1, GP2, turning on/off the M1 and M2 in a short period of time has been considered preferable for reducing loss due to on-resistances of the transistors M1, M2 to improve efficiency. Thus, as enlarged and shown in Fig. 5, the gate driving pulses GP1, GP2 have been formed so that rising edges and falling edges thereof become steep and the falling times tf1, tf2 and the rising times tr1, tr2 do not overlap with each other respectively. However, when the pulse has steep edges as described above, the spike noise easily occurs. Moreover, the spike noise has high frequency and cannot be removed by a filter circuit including the coil L and a smoothing condenser C. Thus, we realized that there is a problem that the spike noise enters the input voltage Vin as a noise and becomes a cause to adversely affect other circuits which shares the power source voltage.

The technique described in above-mentioned Japanese Patent Application Laid-Open Publication No. 2004-112958 provides a spike noise detection circuit and an additional transistor which has large on-resistance and is connected to a driving switching element (driver transistor) for applying current to a coil in parallel so as to turn the additional transistor on when the spike noise is detected so that the noise is reduced. However, such technique has a problem that a circuit size becomes large so that a chip size becomes enlarged.

### SUMMARY OF THE INVENTION

US2006/132113 A1 relates to a DC-DC convertor in which a rising time is determined by a variable resistor. Furthermore the variable resistor value is set according to the load current. Thus, reference D1 does not disclose the adjustment of the size of the first drive circuit in order to achieve a longer rising time.

XP011043606 relates to an improved efficiency back convertor with a resonant drive. For this purpose the resonant drive recycles the energy stored in the gate source capac of a transistor SR.

The present invention is achieved in view of the above problems, and an object of the present invention is to provide a technique capable of reduce spike noise in a DC-DC converter of switching regulator type.

The other object of the present invention is to provide a DC-DC converter capable of reducing spike noise due to switching operation, and a switching control circuit constructing the DC-DC converter.
The objects of the invention are achieved by the subject matter of the independent claims, advantageous embodiments are subject to the dependent claims.

In order to achieve the above object, according to a first aspect of the present invention, there is provided a switching control circuit including: a first drive circuit to generate a drive signal for driving a driving switching element to flow current through an inductor for voltage conversion into on/off states; wherein the first drive circuit generates the drive signal so that a transition time of the drive signal in which the driving switching element shifts from an off state to an on state becomes longer than a transition time of the drive signal in which the driving switching element shifts from the on state to the off state.

### BRIEF DESCRIPTION OF THE DRAWINGS

The above and other objects, advantages and features of the present invention will become more fully understood from the detailed description given hereinbelow and the appended drawings which are given by way of illustration only, and thus are not intended as a definition of the limits of the present invention, and wherein:
FIG. 1 is a circuit configuration diagram showing one embodiment of a synchronous rectification type DC-DC converter to which the present invention is applied;
FIG. 2 is a waveform diagram showing changes of gate drive signals GP1, GP2 for driving a driving switching transistor M1 and a rectifying switching transistor M2 of the DC-DC converter of the embodiment into on/off states;
FIG. 3 is a block configuration diagram showing a schematically configuration of a general synchronous rectification type DC-DC converter;
FIG. 4 is a timing chart showing timing of changes of gate drive signals GP1, GP2 for driving a driving switching transistor M1 and a rectifying switching transistor M2 of a conventional DC-DC converter into on/off states; and
FIG. 5 is a waveform diagram in which the gate drive signals Gp1, GP2 of the conventional DC-DC converter are enlarged to be shown.

### DETAILED DESCRIPTION OF THE INVENTION

In the following, the preferred embodiments of the present invention will be described with reference to the drawings.

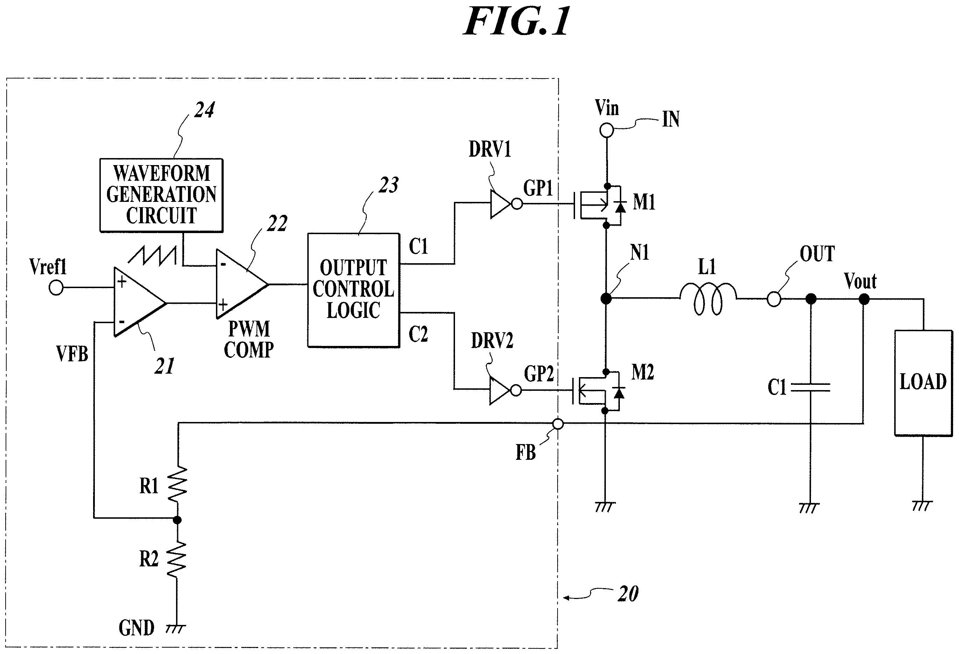

FIG. 1 shows one embodiment of a DC-DC converter of switching regulator type to which the present invention is applied.

The DC-DC converter of the embodiment includes: a coil L1 as an inductor; a driving switching transistor M1 composed of a P-channel MOSFET (insulated gate field effect transistor) which is connected between a voltage input terminal IN to which a direct input voltage Vin is applied and one terminal of the coil L1, and applies drive current into the coil L1; and a rectifying switching transistor M2 composed of an N-channel MOSFET connected between the one terminal of the coil L1 and a ground point.

The DC-DC converter further includes a switching control circuit 20 to drive the switching transistors M1, M2 into on/off states, and a smoothing condenser C1 connected between the other terminal (output terminal OUT) of the coil L1 and the ground point.

Among elements constructing the DC-DC converter of the embodiment, the switching control circuit 20 is formed on a semiconductor chip to construct a semiconductor integrated circuit (power source controlling IC), and the coil L1, the condenser C1, and the transistors M1, M2 as switching elements are connected to an external terminal provided in the IC as external elements, though the present invention is not limited to this configuration.

In the DC-DC converter of the embodiment, the switching control circuit 20 generates driving pulses GP1, GP2 to allow the transistors M1, M2 to be on/off in a complementary style. In a steady state, when the driving transistor M1 is turned on, the direct input voltage Vin is applied to the coil L1 so that current toward the output terminal OUT flows to charge the smoothing condenser C1.

When the driving transistor M1 is turned off, the rectifying transistor M2 is turned on instead of the M1, and current flows to the coil L1 though the turned-on rectifying transistor M2. Then, by controlling pulse widths of the driving pulse GP1, GP2 to be input to control terminals (gate terminal) of the M1, M2 depending on an output voltage for example by allowing switching periods to be constant, a direct output voltage Vout obtained by lowering the direct input voltage Vin occurs.

The switching control circuit 20 includes: resistances R1, R2 connected in series between a terminal FB to which a voltage from the output terminal OUT is fed back and the ground point to divide the output voltage Vout by a resistance ratio; an error amplifier 21 to compare the voltage VFB divided by the resistances R1, R2 with a reference voltage Vref1 to output a voltage depending on a potential difference; and a PWM comparator 22 to one of input terminals of which an output of the error amplifier 21 is input.

The switching control circuit 20 further includes: an output control logic 23 to generate control pulses C1, C2 for allowing the switching transistors M1, M2 to be turned on/off so that their on-periods do not overlap with each other based on an output pulse of the PWM comparator 22; and output drivers DRV1, DRV2 composed of a CMOS inverter to receive the control pulses C1, C2 to generate and output the gate drive signals GP1, GP2 respectively for the switching transistors M1, M2.

To the other input terminal of the PWM comparator 22, a waveform signal is input from a waveform generation circuit 24 which houses an oscillator and generates waveform signals of predetermined frequency such as a triangle wave and saw-tooth wave. The PWM comparator 22 performs the control so that a pulse width of an output driving pulse becomes narrow when the output voltage is high depending on the feedback voltage VFB, and the pulse width becomes broad when the feedback voltage VFB is low.

In the DC-DC converter of the embodiment, the output drivers DRV1, DRV2 are configured to generate the gate drive signals GP1, GP2 each having the desired rising time and the falling time (transition time) as shown in Fig. 2. Specifically, when the falling time of the gate drive signal GP1 is tf1, the rising time thereof is tr1, the falling time of the gate drive signal GP2 is tf2, and the rising time thereof is tr2, the output drivers DRV1, DRV2 are designed so that the falling time of the gate drive signal GP1 is longer than the rising time thereof, namely tf1 > tr1, and so that the rising time of the gate drive signal GP2 is longer than the falling time thereof, namely tf2 < tr2. With respect to the relation between tf1 and tr1, it is preferred that tf1 is 1.5 to 2 times tr1. With respect to the relation between tr2 and tf2, it is preferred that tr2 is 1.5 to 2 times tf2.

Incidentally, the relation between tf1 and tr2 may be tf1 = tr2, and the relation between tf1 and tf2 may be tf1 = tf2. Since electricity losses due to on-resistance components increase when tf1 and tr2 are excessively large, it is preferable to accordingly set tf1 and tr2 within the range of up to 5% or less of switching period (driving pulse period), more preferably within the range of up to 2% or less, when being converted into 1 (one) MHz.

By setting the falling time and the rising time as the transition times of the gate drive signals GP1, GP2 as described above, in the DC-DC converter of the embodiment, a peak value of current which momentarily flows when each of the switching transistors M1, M2 is turned on can be reduced, and thereby an advantage that spike noise is suppressed can be obtained. In addition, by setting tf1 and tr2 to 5% or less of switching period, the peak value of current which momentarily flows when each of M1 and M2 is turned on can be reduced without narrowing a voltage controlling range by PWM control so much.

Next, a concrete method for differentiating the falling times from the rising times respectively in the gate drive signals GP1, GP2 generated in the output drivers DRV1, DRV2 will be described.

In the embodiment, each of the output drivers DRV1, DRV2 is composed of a CMOS inverter in which a P-channel MOSFET and an N-channel transistor are connected to each other in series between a power source terminal VDD and the ground point GND. It is generally known that when comparing the P-channel MOSFET with N-channel transistor which are formed by a current CMOS manufacturing process, the N-channel transistor has a current driving force which is about three times that of the P-channel MOSFET in the case that the N-channel transistor has same size as the P-channel transistor.

For this reason, a general CMOS inverter constituting a logic circuit and the like is designed so that the current driving force of the P-channel MOSFET becomes same as that of N-channel MOSFET and the size of the P-channel MOSFET becomes about three times that of the N-channel transistor. The waveforms of the gate drive signals GP1, GP2 shown in Fig. 5 may be considered to be designed so that a size ratio of the P-channel MOSFET and the N-channel transistor which construct the output drivers DRV1, DRV2 becomes 3:1.

On the other hand, in the embodiment, the size ratio between the P-channel MOSFET and the N-channel transistor which construct the output driver DRV1 is set to be a ratio larger than 3:1, for example 5:1. Thus, the output driver DRV1 is set so that the current driving force of the N-channel transistor becomes smaller than the current driving force of the P-channel transistor.

Since the driving switching transistor M1 is composed of the P-channel MOSFET in the DC-DC converter shown in Fig. 1, the M1 is turned on during the period when the gate drive signal GP1 output from the output driver DRV1 is at low-level. Thus, if the current driving force of the N-channel MOSFET constructing the DRV1 is small, the DC-DC converter operates so that time tf1 in which the N-channel transistor constructing the DRV1 is turned on and the GP1 changes from high level to low level becomes longer than time tr1 in which the P-channel transistor constructions the DRV1 is turned on and the GP1 changes from low level to high level. As a result, a peak value of current which momentarily flows when the switching transistor M1 is switched from off to on can be reduced.

On the other hand, a size ratio between the P-channel MOSFET and the N-channel transistor which construct the output driver DRV2 is set to be a ratio smaller than conventional 3:1, for example 3:4. Thus, the output driver DRV2 is constructed so that the current driving force of the P-channel MOSFET is smaller than the current driving force of the N-channel transistor.

Since the rectifying switching transistor M2 is composed of the N-channel MOSFET in the DC-DC converter shown in Fig. 1, the M2 is turned on during the period when the gate drive signal GP2 output from the output driver DRV2 is at high level. Thus, if the current driving force of the P-channel MOSFET constructing the DRV2 is small, the DC-DC converter operates so that a time tr2 in which the P-channel transistor of the DRV2 is turned on and the GP2 changes from low level to high level becomes longer than a time tf2 in which the N-channel transistor of the DRV2 is turned on and the GP2 changes from high level to low level. As a result, a peak value of current which momentarily flows when the rectifying switching element M2 is switched from off to on can be reduced.

Moreover, comparing the driving switching transistor M1 with the driving switching transistor M2, since the driving switching transistor M1 is the P-channel MOSFET, and since the current driving force of the driving switching transistor M1 becomes smaller than that of the rectifying switching element M2 composed of the N-channel MOSFET when the rectifying switching element M2 has same size as the driving switching transistor M1, the M1 is designed so as to have the size larger (about three-times larger) than that of the M2. For this reason, the sizes of the transistor constructing the output driver DRV1 and the transistor constructing the output driver DRV2 are designed in view of the size ratio between the driving switching transistor M1 and the rectifying switching element M2. This is because the driving switching transistor M1 and the rectifying switching element M2 operate as capacitive loads as seen from the output drivers DRV1, DRV2.

As described above, the DC-DC converter of the embodiment has an advantage that by designing the sizes of each transistor constructing the output driver DRV1 and each transistor constructing the output driver DRV2, the peak value of current which momentarily flows when the driving switching transistor M1 or the rectifying switching element M2 is switched from off to on can be reduced so that the spike noise is suppressed.

According to the principles of the present invention, the above advantage can be obtained in some degree even in the case that the present invention is applied to a diode rectification type DC-DC converter in which a diode is used in stead of the rectifying switching element M2 shown in Fig. 1. However, the advantage becomes especially significant when the present invention is applied to a synchronous rectification type DC-DC converter because the spike noise occurs both of the time when the driving switching transistor M1 is turned on and the time when the rectifying switching element M2 is turned on.

Although the invention created by the present inventors is described in detail based on the embodiment, the present invention is not limited to the above-described embodiment. For example, since it is desirable that the gate drive signals GP1, GP2 are generated so that the periods (tf1 and tf2, and tr1 and tr2) during which the GP1, GP2 are changing do not overlap each other in order to prevent a penetrating current from flowing through the switching elements M1, M2, it is preferable to design the circuits so that the outputs (or inputs) of the output drivers DRV1, DRV2 are fed back to the output control logic 23, the GP1 starts rising when confirming that the GP2 has risen, and the GP2 starts rising when confirming that the GP1 has risen.

Since current flows though a body diode parasitizing to the M2 to increase the loss when the time in which both of the switching elements M1, M2 are turned off is long, it is preferable to allow the time in which the both are turned off to be as short as possible. For this reason, it is preferable to design the circuits so that the CP1 starts rising immediately after the GP2 rises and the CP2 starts rising immediately after the GP1 rises.

Although the external elements formed separately from the power source controlling IC are used as the switching elements M1, M2 in the embodiment, the switching elements M1, M2 may be formed as the power source controlling IC by using on-chip elements formed on the semiconductor chip similarly to the power source controlling IC. Furthermore, though the resistances R1, R2 to divide the output voltage to be applied to the feedback terminal FB are formed on the chip in the embodiment, the voltage-dividing resistances R1, R2 may be constructed as external elements to apply voltages which have been divided outside the chip to the feedback terminal.

In addition, though the switching control circuit housing the circuit to generate the waveform signal (triangle wave) to be input to the PWM comparator 22 on the chip is shown in the embodiment, the switching control circuit can be constructed to receive the waveform signal or an oscillation signal for generating the waveform signal from outside the chip. The present invention also can be applied to a switching control circuit of a DC-DC converter, the switching control circuit being provided with a PFM comparator in addition to the PWM comparator, and performing a voltage converting operation by PFM control in case of light load.

Although the example in which the present invention is applied to a step-down DC-DC converter is described above, the present invention is not limited to the above example and also can be applied to a step-up DC-DC converter or an inverting DC-DC converter to produce a negative voltage.

In order to achieve the above objects, there is provided a switching control circuit including: a first drive circuit to generate a drive signal for driving a driving switching element to flow current through an inductor for voltage conversion into on/off states; wherein the first drive circuit generates the drive signal so that a transition time of the drive signal in which the driving switching element shifts from an off state to an on state becomes longer than a transition time of the drive signal in which the driving switching element shifts from the on state to the off state.

According to the above means, since the peak value of current which momentarily flows when the driving switching element is turned on can be reduced, the spike noise due to driving switching can be suppressed in the DC-DC converter of switching regulator type.

Preferably, the switching control circuit further includes: a second drive circuit to generate a drive signal for a rectifying switching element to rectify current of a coil during a period in which the driving switching element is turned off; wherein the second drive circuit generates the drive signal so that a transition time of the drive signal in which the rectifying switching element shifts from an off state to an on state becomes longer than a transition time of the drive signal in which the rectifying switching element shifts from the on state to the off state. By this, since also the peak value of current which momentarily flows when the rectifying switching element is turned on can be reduced in the synchronous rectification type DC-DC converter, the spike noise due to switching can be further reduced.

Preferably, the driving switching element is composed of a P-channel field-effect transistor, and the rectifying switching element is composed of an N-channel field-effect transistor, and the first drive circuit is constructed to output the drive signal in which the transition time from a high level to a low level is longer than the transition time from the low level to the high level, and the second drive circuit is constructed to output the drive signal in which the transition time from a low level to a high level is longer than the transition time from the high level to the low level. By this, in the DC-DC converter of switching regulator type in which the driving switching element is composed of P-channel field-effect transistor and the rectifying switching element is composed of N-channel field-effect transistor, the peak value of the current which momentarily flows when the switching element is turned on can be reduced.

Preferably, the first and second drive circuits are composed of CMOS inverters, the CMOS inverter as the first drive circuit being formed so that a current driving force of the P-channel field-effect transistor is larger than a current driving force of the N-channel field-effect transistor, and the CMOS inverter as the second drive circuit being formed so that a current driving force of the N-channel field-effect transistor is larger than a current driving force of the P-channel field-effect transistor.

By this, the peak value of the current which momentarily flows when the switching element is turned on can be easily reduced by simple design change without using a drive circuit having a complicated configuration.

Preferably, the transition time from the high level to the low level of the drive signal of the first drive circuit and the transition time from the low level to the high level of the drive signal output from the second drive circuit are 5% or less of periods of the drive signals.

By this, in the DC-DC converter to which PWM control system is applied, the peak value of the current which momentarily flows when the switching element is turned on can be easily reduced without narrowing a voltage control range of PWM control so much.

According to the present invention, it becomes possible to obtain the advantage that the spike noise can be reduced in the DC-DC converter of switching regulator type.

## Claims

1. A switching control circuit for a DC-DC convertor comprising:
a first drive circuit (DRV1) to generate a drive signal for a driving switching element (M1) which flows current through an inductor (L1) of the DC-DC convertor used for voltage conversion, the drive signal which drives the driving switching element (M1) to be in an on state and an off state; and
a second drive circuit (DRV2) to generate a drive signal for a rectifying switching element (M2) to rectify current of the inductor (L1) during a period in which the driving switching element (M1) is turned off, wherein the first drive circuit (DRV1) is configured to output the drive signal in which the transition time from a high level to a low level is longer than the transition time from the low level to the high level, and to generated the drive signal such that a transition
time of the drive signal in which the driving switching element (M1) shifts from the off state to the on state becomes longer than a transition time of the drive signal in which the driving switching element (M1) shifts from the on state to the off state, **characterized in that** the second drive circuit (DRV2) is configured to output the drive signal in which the transition time from a low level to a high level is longer than the transition time from the high level to the low level, and to generated the drive signal such that a transition time of the drive signal in which the rectifying switching element (M2) shifts from an off state to an on state becomes longer than a transition time of the drive signal in which the rectifying switching element (M2) shifts from the on state to the off state, and
the first and second drive circuits (DRV1, DRV2) are composed of CMOS inverters, respectively, each of which includes a P-channel field-effect transistor and an N-channel field-effect transistor, the CMOS inverter as the first drive circuit (DRV1) being formed such that a current driving force of the P-channel field-effect transistor is larger than a current driving force of the N-channel field-effect transistor, and the CMOS inverter as the second drive circuit (DRV2) being formed such that a current
driving force of the N-channel field-effect transistor is larger than a current driving force of the P-channel field-effect transistor.

2. The switching control circuit according to claim 1, wherein the transition time from the high level to the low level of the drive signal output from the first drive circuit (DRV1) and the transition time from the low level to the high level of the drive signal output from the second drive circuit (DRV2) are 5% or less of periods of the drive signals, respectively.

3. A DC-DC converter comprising:
an inductor used (L1) for voltage conversion;
a driving switching element (M1) to flow current through the inductor;
a rectifying switching element (M2) to rectify the current of the inductor (L1) during a period in which the driving switching element (M1) is turned off;
a smoothing condenser connected to an output terminal; and
the switching control circuit (20) according to claim 1 or 2 to generate the driving signals for the driving switching element (M1) and the rectifying switching element (M2).

4. The DC-DC converter according to claim 3, wherein the driving switching element (M1) is composed of a P-channel field-effect transistor, and the rectifying switching element (M2) is composed of an N-channel field-effect transistor.

## Patentansprüche

1. Schaltung zur Steuerung von Schaltvorgängen für einen Gleichspannungswandler, mit:
einer ersten Treiberschaltung (DRV1) zur Erzeugung eines Treibersignals für ein ansteuerndes Schaltelement (M1), das Strom in eine Induktivität (L1) des Gleichspannungswandlers, die zur Spannungsumwandlung verwendet wird, einprägt, wobei das Treibersignal das ansteuernde Schaltelement (M1) so ansteuert, dass dieses in einem eingeschalteten Zustand oder einem ausgeschalteten Zustand ist; und
einer zweiten Treiberschaltung (DRV2) zur Erzeugung eines Treibersignals für ein Gleichrichter-Schaltelement (M2) zur Gleichrichtung von Strom der Induktivität (L1) während einer Zeitdauer, in der das ansteuernde Schaltelement (M1) ausgeschaltet ist,
wobei die erste Treiberschaltung (DRV1) ausgebildet ist, das Treibersignal auszugeben, in welchem die Übergangszeit von einem hohen Pegel zu einem niedrigen Pegel länger ist als die Übergangszeit von dem niedrigen Pegel zu dem hohen Pegel, und das Treibersignal derart zu erzeugen, dass eine Übergangszeit des Treibersignals, in der das ansteuernde Schaltelement (M1) von dem ausgeschalteten Zustand in den eingeschalteten Zustand übergeht, länger ist als eine Übergangszeit des Treibersignals, in der das ansteuernde Schaltelement (M1) von dem eingeschalteten Zustand in den ausgeschalteten Zustand übergeht,
**dadurch gekennzeichnet, dass**
die zweite Treiberschaltung (DRV2) ausgebildet ist, das Treibersignal auszugeben, in welchem die Übergangszeit von einem niedrigen Pegel zu einem hohen Pegel länger ist als die Übergangszeit von dem hohen Pegel zu dem niedrigen Pegel, und das Treibersignal derart zu erzeugen, dass eine Übergangszeit des Treibersignals, in der das Gleichrichter-Schaltelement (M2) von einem ausgeschalteten Zustand in einen eingeschalteten Zustand übergeht, länger ist als eine Übergangszeit des Treibersignals, in der das Gleichrichter-Schaltelement (M2) von dem eingeschalteten Zustand in den ausgeschalteten Zustand übergeht, und
die erste und die zweite Treiberschaltung (DRV1, DRV2) aus einem entsprechenden CMOS-Inverter aufgebaut sind, wovon jeder einen P-Kanal-Feldeffekttransistor und einen N-Kanal-Feldeffekttransistor aufweist, wobei der CMOS-Inverter für die erste Treiberschaltung (DRV1) so ausgebildet ist, dass eine Strombelastbarkeit des P-Kanal-Feldeffekttransistors größer ist als eine Strombelastbarkeit des N-Kanal-Feldeffekttransistors, und der CMOS-Inverter für die zweite Treiberschaltung (DRV2) so ausgebildet ist, dass eine Strombelastbarkeit des N-Kanal-Feldeffekttransistors größer ist als eine Strombelastbarkeit des P-Kanal-Feldeffekttransistors.

2. Schaltung zur Steuerung der Schaltvorgänge nach Anspruch 1, wobei die Übergangszeit von dem hohen Pegel zu dem niedrigen Pegel des von der ersten Treiberschaltung (DRV1) ausgegebenen Treibersignals und die Übergangszeit von dem niedrigen Pegel zu dem hohen Pegel des von der zweiten Treiberschaltung (DRV2) ausgegebenen Treibersignals 5 % oder weniger der Periode der Treibersignale einnehmen.

3. Gleichspannungswandler, mit:
einer Induktivität (L1), die zur Spannungsumwandlung verwendet ist;
einem ansteuernden Schaltelement (M1), das der Induktivität einen Strom einprägt;
einem Gleichrichter-Schaltelement (M2) zum Gleichrichten des Stroms der Induktivität (L1) während einer Zeitdauer, in der das ansteuernde Schaltelement (M1) ausgeschaltet ist;
einem Glättungskondensator, der mit einem Ausgangsanschluss verbunden ist; und
der Schaltung zur Steuerung von Schaltvorgängen (20) nach Anspruch 1 oder 2 zur Erzeugung der Treibersignale für das ansteuernde Schaltelement (M1) und das Gleichrichter-Schaltelement (M2).

4. Gleichspannungswandler nach Anspruch 3, wobei das ansteuernde Schaltelement (M1) aus einem P-Kanal-Feldeffekttransistor aufgebaut ist und das Gleichrichter-Schaltelement (M2) aus einem N-Kanal-Feldeffekttransistor aufgebaut ist.

## Revendications

1. Circuit de commande de commutation pour un convertisseur CC-CC, comprenant :
un premier circuit de commande (DRV1) pour générer un signal de commande pour un élément de commutation de commande (M1) qui fait circuler du courant à travers un inducteur (L1) du convertisseur CC-CC utilisé pour une conversion de tension, signal de commande qui commande l'élément de commutation de commande (M1) pour être dans un état allumé et éteint ; et
un second circuit de commande (DRV2) pour générer un signal de commande pour un élément de commutation redresseur (M2), pour redresser le courant de l'inducteur (L1) pendant une période pendant laquelle l'élément de commutation de commande (M1) est désactivé,
dans lequel le premier circuit de commande (DRV1) est configuré pour délivrer en sortie le signal de commande dans lequel le temps de transition d'un niveau haut à un niveau bas est plus long que le temps de transition du niveau bas au niveau haut, et pour générer le signal de commande de telle sorte qu'un temps de transition du signal de commande durant lequel l'élément de commutation de commande (M1) passe de l'état éteint à l'état allumé devient plus long qu'un temps de transition du signal d'attaque durant lequel l'élément de commutation de commande (M1) passe de l'état allumé à l'état éteint,
**caractérisé en ce que** le second circuit de commande (DRV2) est configuré pour délivrer en sortie le signal de commande dans lequel le temps de transition d'un niveau bas à un niveau haut est plus long que le temps de transition du niveau haut au niveau bas, et pour générer le signal de commande de telle sorte qu'un temps de transition du signal de commande durant lequel l'élément de commutation redresseur (M2) passe d'un état éteint à un état allumé devient plus long qu'un temps de transition du signal de commande durant lequel l'élément de commutation redresseur (M2) passe de l'état allumé à l'état éteint, et
les premier et second circuits de commande (DRV1, DRV2) sont respectivement constitués d'inverseurs CMOS, dont chacun comprend un transistor à effet de champ à canal P et un transistor à effet de champ à canal N, l'inverseur CMOS en tant que premier circuit de commande (DRV1) étant formé de telle sorte qu'une force de commande de courant du transistor à effet de champ à canal P est plus grande qu'une force de commande de courant du transistor à effet de champ à canal N, et l'inverseur CMOS en tant que second circuit de commande (DRV2) étant formé de telle sorte qu'une force de commande de courant du transistor à effet de champ à canal N est plus grande qu'une force de commande de courant du transistor à effet de champ à canal P.

2. Circuit de commande de commutation selon la revendication 1, dans lequel le temps de transition entre le niveau haut et le niveau bas du signal de commande délivré en sortie par le premier circuit de commande (DRV1) et le temps de transition du niveau bas au niveau haut du signal de commande délivré en sortie par le second circuit de commande (DRV2) correspondent à 5 % ou moins de périodes des signaux de commande, respectivement.

3. Convertisseur CC-CC comprenant :
un inducteur (L1) utilisé pour une conversion de tension ;
un élément de commutation de commande (M1) pour faire circuler du courant à travers l'inducteur ;
un élément de commutation redresseur (M2) pour redresser le courant de l'inducteur (L1) pendant une période durant laquelle l'élément de commutation d'entraînement (M1) est désactivé ;
un condenseur de lissage connecté à une borne de sortie ; et
le circuit de commande de commutation (20) selon la revendication 1 ou 2 pour générer les signaux de commande pour l'élément de commutation de commande (M1) et l'élément de commutation redresseur (M2).

4. Convertisseur CC-CC selon la revendication 3, dans lequel l'élément de commutation de commande (M1) est constitué d'un transistor à effet de champ à canal P, et l'élément de commutation redresseur (M2) est constitué d'un transistor à effet de champ à canal N.
